# EUROPEAN PATENT APPLICATION

(11) **EP 4 734 698 A1**
(43) Date of publication of application: **29.04.2026**
(21) Application number: 25184704.2
(22) Date of filing: 23.06.2025
(51) Int. Cl.: H10D 30/66, H10D 62/10, H10D 62/832

(54) **SEMICONDUCTOR DEVICE**

(30) Priority: 22.10.2024 KR 20240144911
(71) Applicant: Samsung Electronics Co., Ltd., Suwon-si, Gyeonggi-do 16677 (KR)
(72) Inventor: KIM, Taehun, Suwon-si (KR); PARK, Young Hwan, Suwon-si (KR); KO, Mingu, Suwon-si (KR); PARK, Jeonghwan, Suwon-si (KR); OH, Sewoong, Suwon-si (KR); WOO, Sangsu, Suwon-si (KR)
(74) Representative: Marks & Clerk LLP

(57) **Abstract**

A semiconductor device according to an embodiment of the present disclosure includes: a first conductivity type substrate; a first conductivity type epitaxial layer disposed on a first surface of the first conductivity type substrate; a gate trench disposed in the first conductivity type epitaxial layer; a gate electrode disposed within the gate trench; a gate insulating layer disposed between the first conductivity type epitaxial layer and the gate electrode; a source electrode disposed above the first conductivity type epitaxial layer; a second conductivity type doping well provided with the first conductivity type epitaxial layer and disposed between the first conductivity type epitaxial layer and the source electrode; a drain electrode disposed on a second surface of the first conductivity type substrate; and a barrier pattern provided with the first conductivity type epitaxial layer. The barrier pattern includes a first portion disposed on a lower surface of the gate trench and a second portion connected to the first portion and disposed between the first conductivity type epitaxial layer and the second conductivity type doping well. The first and second portions are elongated in different directions from each other.

## Description

### BACKGROUND

### 1. Field

The present disclosure relates to a semiconductor device.

### 2. Description of the Related Art

In modern society, a semiconductor device is closely related to daily life. In particular, an importance of an electric power semiconductor device used in various fields such as a transportation field (e.g., an electric vehicle, a railway vehicle, an electric tram, or the like), a renewable energy system (e.g., a solar power generation system, a wind power generation system, or the like), and a mobile device is gradually increasing. The electric power semiconductor device is a semiconductor device used to handle a high voltage or a high current, and performs a function such as electric power conversion or control in a large electric power system or a high-power electronic device. The electric power semiconductor device may have ability handling high electric power and durability, so that it handles large amounts of current and withstands a high voltage. For example, the electric power semiconductor device may handle a voltage with hundreds to thousands of volts and a current with tens of amperes to thousands of amperes. The electric power semiconductor device may improve the efficiency of electrical energy by minimizing electric power loss. Additionally, the electric power semiconductor device may be stably driven even in an environment such as a high-temperature environment.

The electric power semiconductor device may be classified according to its material, and for example, it may include a SiC power semiconductor device and a GaN power semiconductor device. A disadvantage of silicon that has an unstable characteristic at a high temperature may be compensated by manufacturing the electric power semiconductor device using SiC or GaN instead of an existing silicon (Si) wafer. The SiC power semiconductor device may be strong at a high temperature, may have low electric power loss, and may be suitable for the electric vehicle, the renewable energy system, or the like. The GaN power semiconductor device may require a high cost, but it may be efficient in terms of speed and may be suitable for high-speed charging or the like of the mobile device.

### SUMMARY

Embodiments are intended to provide a semiconductor device capable of improving reliability and/or degree of integration.

A semiconductor device according to an embodiment of the present disclosure includes: a first conductivity type substrate; a first conductivity type epitaxial layer disposed on a first surface of the first conductivity type substrate; a gate trench disposed in the first conductivity type epitaxial layer; a gate electrode disposed within the gate trench; a gate insulating layer disposed between the first conductivity type epitaxial layer and the gate electrode; a source electrode disposed above the first conductivity type epitaxial layer; a second conductivity type doping well provided with the first conductivity type epitaxial layer and disposed between the first conductivity type epitaxial layer and the source electrode; a drain electrode disposed on a second surface of the first conductivity type substrate; and a barrier pattern provided with the first conductivity type epitaxial layer. The barrier pattern includes a first portion disposed on a lower surface of the gate trench and a second portion connected to the first portion and disposed between the first conductivity type epitaxial layer and the second conductivity type doping well. The first and second portions may be elongated in different directions from each other.

A semiconductor device according to another embodiment includes: a first conductivity type substrate; a first conductivity type epitaxial layer disposed on a first surface of the first conductivity type substrate; a gate trench disposed in the first conductivity type epitaxial layer; a gate electrode disposed within the gate trench; a gate insulating layer disposed between the first conductivity type epitaxial layer and the gate electrode; a source electrode disposed above the first conductivity type epitaxial layer; a second conductivity type doping well provided with the first conductivity type epitaxial layer and disposed between the first conductivity type epitaxial layer and the source electrode; a drain electrode disposed on a second surface of the first conductivity type substrate; and a barrier pattern provided with the first conductivity type epitaxial layer. The barrier pattern includes a first portion disposed on a lower surface of the gate trench and a second portion connected to the first portion and disposed on a lower surface of the second conductivity type doping well. The first and second portions may be elongated in different directions from each other. A width of the first portion may be less than or equal to a width of the gate electrode.

A semiconductor device according to another embodiment includes: a first conductivity type substrate; a first conductivity type epitaxial layer disposed on a first surface of the first conductivity type substrate; a plurality of gate trenches disposed in the first conductivity type epitaxial layer, extending in a first direction, and spaced apart in a second direction intersecting the first direction; a plurality of gate electrodes that are disposed within the plurality of gate trenches; a gate insulating layer disposed between the first conductivity type epitaxial layer and the gate electrode; a source electrode disposed above the first conductivity type epitaxial layer; a second conductivity type doping well disposed between the first conductivity type epitaxial layer and the source electrode; a drain electrode disposed on a second surface of the first conductivity type substrate; and a barrier pattern having second conductivity type. The barrier pattern includes a first portion disposed on a lower surface of each of the plurality of gate trenches and extending in the first direction and a second portion extending in the second direction and disposed between the first conductivity type epitaxial layer and the second conductivity type doping well. A width of the first portion along the second direction may be less than or equal to a width of the gate electrode along the second direction.

A power semiconductor transistor according to an embodiment includes: a semiconductor layer having first conductivity type and a crystalline structure; a barrier pattern provided with the semiconductor layer; a second conductivity type doping region provided with the semiconductor layer; a pair of first conductivity type doping layers provided with the semiconductor layer; a first conductive electrode formed on a first surface of the semiconductor layer; a second conductive electrode formed on a second surface of the semiconductor layer; a gate electrode disposed in a gate trench; and a gate insulating layer disposed between the semiconductor layer and the gate electrode. The first and second surfaces of the semiconductor layer face away from each other. The gate trench is formed within the semiconductor layer and extends in a first direction. The pair of first conductivity type doping layers are disposed within the second conductivity type doping region, and spaced apart from the semiconductor layer by the second conductivity type doping region. The first conductive electrode is directly electrically connected to the barrier pattern through the second conductivity type doping region. The barrier pattern is disposed on a bottom portion of the gate trench, and in contact with the second conductivity type doping region. The gate electrode has a first portion and a second portion, which are apart from each other in the first direction in a plan view. In the first portion of the gate electrode, in a cross-sectional view, the pair of first conductivity type doping layers are in contact with the gate insulating layer and in contact with the first conductive electrode. In the second portion of the gate electrode, in a cross-sectional view, the second conductivity type doping region is in contact with two opposite sides of the gate insulating layer and in contact with the first conductive electrode.

References to a first feature being provided with a second feature (e.g., the barrier pattern provided with the first conductivity epitaxial layer) may be a reference to the first feature being formed in (as part of) the second feature. A first feature formed with a second feature may not be materially distinctive from the second feature so as to have a lack of material continuity.

According to an aspect of the embodiments, reliability and/or degree of integration of a semiconductor device may be improved.

At least some of the above and other features of the disclosure are set out in the claims.

### BRIEF DESCRIPTION OF THE DRAWINGS

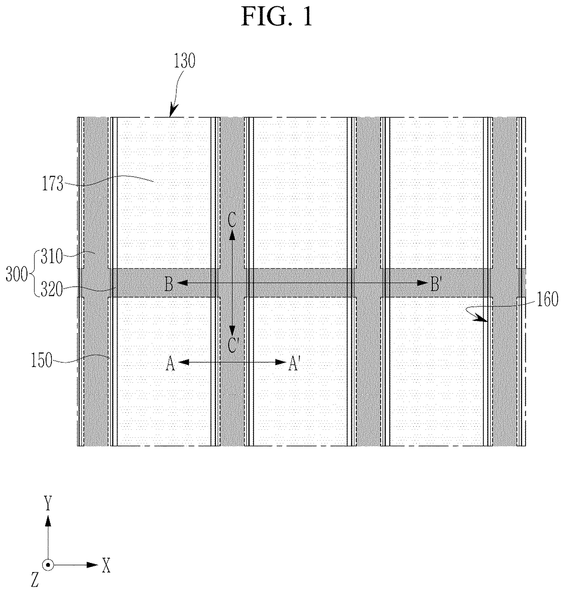

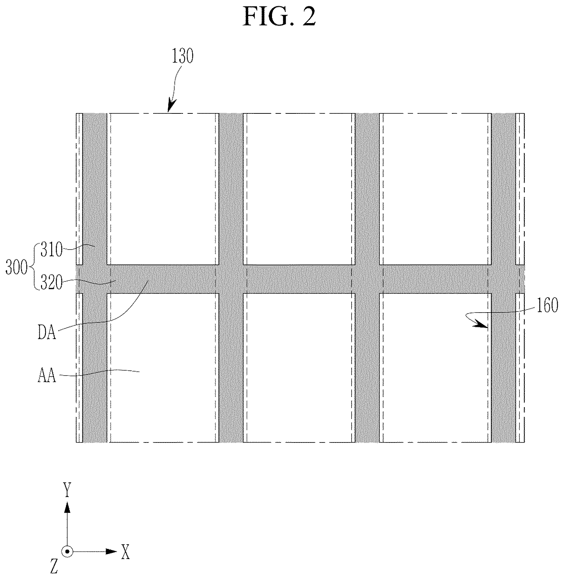

Each of FIG. 1 and FIG. 2 is a plan view showing a semiconductor device according to an embodiment.
FIG. 3 is a cross-sectional view cut along a line A-A' of FIG. 1.
FIG. 4 is a cross-sectional view cut along a line B-B' of FIG. 1.
FIG. 5 is a cross-sectional view cut along a line C-C' of FIG. 1.
FIG. 6 is a plan view showing a semiconductor device according to some embodiments.
FIG. 7 is a cross-sectional view cut along a line D-D' of FIG. 6.
FIG. 8 is a cross-sectional view cut along a line E-E' of FIG. 6.
Each of FIGS. 9 to 11 is a cross-sectional view corresponding to the line B-B' of FIG. 1 showing a semiconductor device according to some embodiments.
FIG. 12 is a plan view showing a semiconductor device according to some embodiments.
FIG. 13 is a cross-sectional view cut along a line F-F' of FIG. 12.
Each of FIGS. 14 to 17 is a plan view showing a semiconductor device according to some embodiments.

### DETAILED DESCRIPTION

Embodiments of the present disclosure will be described more fully hereinafter with reference to the accompanying drawings so that those skilled in the art could easily implement the invention. The present disclosure may be modified in various ways, all without departing from the scope of the present invention.

In order to clearly describe the present invention, the detailed explanation and illustrations of certain functions or components may be omitted. These functions or components can be added by those skilled in the art to accommodate various modifications of the invention, without obscuring the aspects of the invention. Identical or similar constituent elements throughout the specification are denoted by the same or similar reference numerals.

In the drawings, each element's size and thickness may be arbitrarily illustrated for ease of description, but embodiments of the present invention may not be necessarily limited to those illustrated in the drawings. In the drawings, the thicknesses of some layers and areas may be exaggerated for clarity.

It should be understood that when an element such as a layer, a film, a region, or a plate is referred to as being "on" or "above" another element, it may be directly on the other element, or an intervening element may also be present. In contrast, when an element is referred to as being "directly on" another element, there is no intervening element present. Further, in the specification, the word "on" or "above" means disposed on or below a referenced part, and does not necessarily mean disposed on the upper side of the referenced part based on a gravitational direction. In addition, it will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Unless explicitly stated to the contrary, the word "comprise" and variations such as "comprises" and "comprising" should be understood to imply the inclusion of stated elements but not the exclusion of any other elements. In addition, when a component is described as "including" a particular element or group of elements, it is to be understood that the component may be formed of only the element or the group of elements, or the element or group of elements may be combined with additional elements to form the component, unless the context indicates otherwise. The term "consisting of," on the other hand, indicates that a component is formed only of the element(s) listed.

Throughout the specification, the phrase "in a plan view" or "on a plane" may mean when an object portion is viewed from above, and the phrase "in a cross-sectional view" or "on a cross-section" may mean when a cross-section taken by vertically cutting an object portion is viewed from the side.

Items described in the singular herein may be provided in plural, as can be seen, for example, in the drawings. Thus, the description of a single item that is provided in plural should be understood to be applicable to the remaining plurality of items unless context indicates otherwise.

Terms such as 'same,' 'equal,' 'planar,' 'coplanar,' 'parallel,' and 'perpendicular,' as used herein, are intended to encompass meanings that include typical variations resulting from conventional manufacturing processes and/or accommodate tolerances acceptable in the manufacturing process of the semiconductor device, unless the context or other statements indicate otherwise. For example, 'same' and 'equal' may encompass identicality or near identicality. The term "substantially" may be used herein to emphasize this meaning.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

Hereinafter, a semiconductor device according to an embodiment will be described with reference to FIGS. 1 to 5.

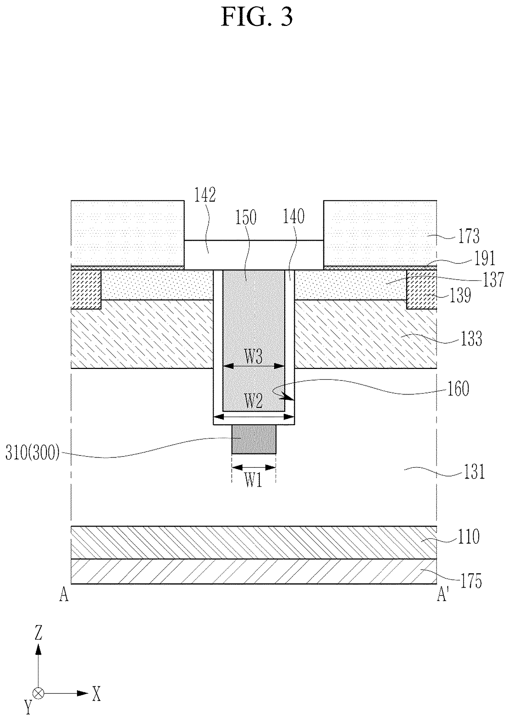

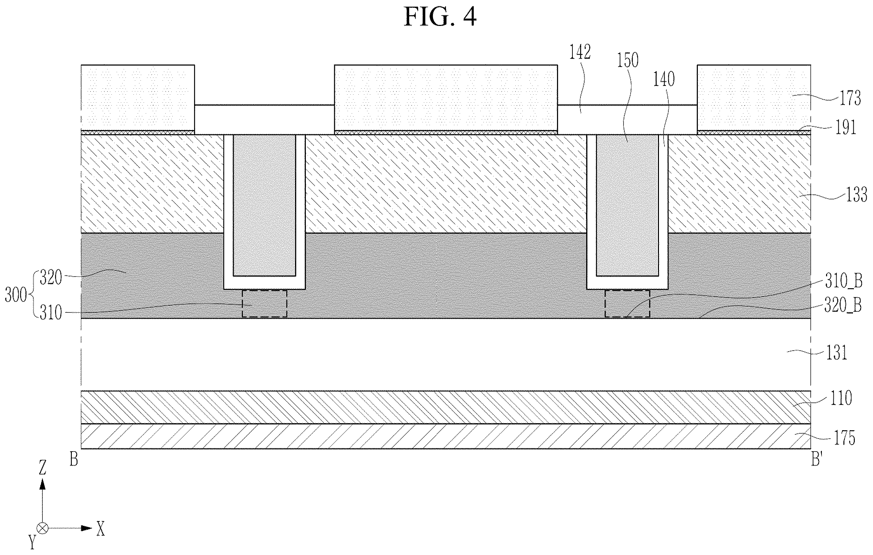

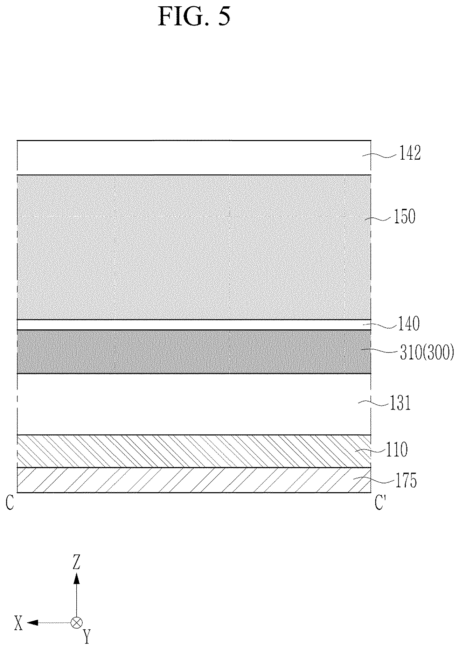

Each of FIG. 1 and FIG. 2 is a plan view showing a semiconductor device according to an embodiment. FIG. 3 is a cross-sectional view cut along a line A-A' of FIG. 1. FIG. 4 is a cross-sectional view cut along a line B-B' of FIG. 1. FIG. 5 is a cross-sectional view cut along a line C-C' of FIG. 1. For ease of description, only a barrier pattern 300 and a gate trench 160 are illustrated in FIG. 2, with illustrations of the remaining components omitted.

Referring to FIGS. 1 to 5, the semiconductor device according to the embodiment may include a first conductivity type substrate 110, a first conductivity type epitaxial layer 131 disposed on a first surface of the first conductivity type substrate 110 and including a gate trench 160, a gate electrode 150 disposed within the gate trench 160, a gate insulating layer 140 disposed between the first conductivity type epitaxial layer 131 and the gate electrode 150, a source electrode 173 disposed above the first conductivity type epitaxial layer 131, a second conductivity type doping well 133 disposed between the first conductivity type epitaxial layer 131 and the source electrode 173, a drain electrode 175 disposed on a second surface of the first conductivity type substrate 110, and the barrier pattern 300 disposed on the first conductivity type epitaxial layer 131.

The first conductivity type substrate 110 may be a semiconductor substrate including silicon carbide (SiC). For example, the first conductivity type substrate 110 may be a semiconductor layer having a crystalline structure (e.g., a single-crystalline structure). The first conductivity type substrate 110 may be made of a 4H SiC substrate (SiC substrate having a 4H crystal structure). In some embodiments, the first conductivity type substrate 110 may be formed of a 3C SiC substrate, a 6H SiC substrate, or the like. The first conductivity type substrate 110 may be doped with an n-type impurity (charge carrier dopants). The first conductivity type substrate 110 may be doped with an n-type impurity with a high concentration. A resistivity of the first conductivity type substrate 110 may be greater than or equal to about 0.005 Ωcm and less than or equal to about 0.035 Ωcm. A thickness of the first conductivity type substrate 110 may be about 10 µm or more and about 700 µm or less. A material, a doping type, a doping concentration, a resistivity, a thickness, and the like of the first conductivity type substrate 110 are not limited thereto, and may be variously changed. The first conductivity type substrate 110 may include the first surface and the second surface facing each other. The first surface of the first conductivity type substrate 110 may be an upper surface of the first conductivity type substrate 110, and the second surface of the first conductivity type substrate 110 may be a lower surface of the first conductivity type substrate 110.

In semiconductor technology, if a semiconductor contains both p-type and n-type impurities, the conductivity type of the semiconductor will be determined by which type of impurity is in greater concentration. Therefore, if a semiconductor has both p-type and n-type impurities, the net conductivity type will be determined by the dominant impurity concentration. As used herein, a "concentration" in a semiconductor region refers to the net concentration of the dominant impurities in the semiconductor region (e.g., the absolute value of the difference between the number (or amount) of p-type impurities and the number (or amount) of n-type impurities per unit volume of the semiconductor region, with the larger quantity being subtracted by the smaller one). In the specification, first conductivity type and second conductivity type may be described as n-type and p-type, respectively, or vice versa. For example, if an element has first conductivity type (e.g., n-type), the net conductivity type determined by the dominant impurity concentration is first conductivity type. For example, the "concentration of (a) dopant(s)" or "doping concentration" in a semiconductor region may refer to either the average concentration or the maximum concentration in the semiconductor region.

The first conductivity type epitaxial layer 131 may be disposed on the first surface (e.g., the upper surface) of the first conductivity type substrate 110. The first conductivity type epitaxial layer 131 may be disposed directly on the first conductivity type substrate 110 (e.g., directly on the first or upper surface of the first conductivity type substrate 110). The first conductivity type epitaxial layer 131 may be disposed on the first conductivity type substrate 110 in the Z direction. A lower surface of the first conductivity type epitaxial layer 131 may be in contact with the upper surface of the first conductivity type substrate 110. However, the present invention is not limited thereto, and another predetermined layer may be further disposed between the first conductivity type substrate 110 and the first conductivity type epitaxial layer 131.

The first conductivity type epitaxial layer 131 may be an epitaxial layer formed from the first conductivity type substrate 110 using epitaxial growth (e.g., the first conductivity type substrate 110 may be used as a seed material for the epitaxial growth). For example, the first conductivity type epitaxial layer 131 may be a semiconductor layer having a single-crystalline structure. The first conductivity type substrate 110 and the first conductivity type epitaxial layer 131 may be a continuous structure formed of the same material (e.g., SiC) without a clear boundary interface therebetween. The first conductivity type substrate 110 and the first conductivity type epitaxial layer 131 may have the same crystalline structure (e.g., one of 4H SiC, 3C SiC and 6H SiC) as each other. The first conductivity type substrate 110 and the first conductivity type epitaxial layer 131 may have different doping concentrations from each other.

The first conductivity type epitaxial layer 131 may include SiC. For example, the first conductivity type epitaxial layer 131 may include 4H SiC. The first conductivity type epitaxial layer 131 may be doped with an n-type impurity. The first conductivity type epitaxial layer 131 may be doped with an n-type impurity with a low concentration. A doping concentration of the first conductivity type epitaxial layer 131 may be lower than a doping concentration of the first conductivity type substrate 110. The doping concentration of the first conductivity type epitaxial layer 131 may be about 1*10¹⁵ cm⁻³ or more and about 1*10¹⁷ cm⁻³ or less. A thickness of the first conductivity type epitaxial layer 131 may be about 1 µm or more and about 13 µm or less. A material, a doping type, a doping concentration, a thickness, and the like of the first conductivity type epitaxial layer 131 are not limited thereto, and may be variously changed.

The first conductivity type epitaxial layer 131 may include the gate trench 160. The gate trench 160 may be formed to have a predetermined depth on an upper surface of the first conductivity type epitaxial layer 131. As shown in FIG. 3 and FIG. 4, the gate trench 160 may be formed in an approximately U-shape in a cross-sectional view. The gate trench 160 may include a bottom surface and a side wall extending from the bottom surface. Although FIG. 3 and FIG. 4 illustrate that an angle of the side wall with respect to the bottom surface of the gate trench 160 is vertical, the present invention is not limited thereto.

The gate trench 160 may extend in a second direction (a Y direction). The semiconductor device according to the embodiment may include a plurality of gate trenches 160 extending in the second direction (the Y direction). For example, the plurality of gate trenches 160 may be provided to extend in the second direction (the Y direction). Each of the plurality of gate trenches 160 may extend in a direction parallel to each other. The plurality of gate trenches 160 may be disposed to be spaced apart from each other in a first direction (an X direction). The second direction (the Y direction) may mean a direction intersecting the first direction (the X direction). For example, the second direction (the Y direction) may be a direction orthogonal to the first direction (the X direction).

In an embodiment, each of the plurality of gate trenches 160 may include a bottom surface and a side wall extending from the bottom surface. The bottom surface of each of the plurality of gate trenches 160 may be defined by the first conductivity type epitaxial layer 131 and the barrier pattern 300 to be described later. The side wall of each of the plurality of gate trenches 160 may be defined by the first conductivity type epitaxial layer 131, the second conductivity type doping well 133, a first conductivity type doping layer 137, and the barrier pattern 300 to be described later.

In an embodiment, a plurality of unit cell areas 130 may be defined by the plurality of gate trenches 160. For example, as illustrated in FIG. 2, the semiconductor device according to the embodiment may include the plurality of unit cell areas 130 defined by the plurality of gate trenches 160. The plurality of unit cell areas 130 may extend in the second direction (the Y direction), and may be disposed to be spaced apart from each other in the first direction (the X direction). The plurality of unit cell areas 130 may be separated from each other by the plurality of gate trenches 160. For example, the gate trench 160 may be disposed between the plurality of unit cell areas 130 adjacent in the first direction (the X direction).

Each of the plurality of unit cell areas 130 of the semiconductor device according to the embodiment may include a dummy area DA and an active area AA. The dummy area DA may be disposed within the plurality of unit cell areas 130. For example, the dummy area DA may extend in the first direction (the X direction) between the plurality of gate trenches 160 adjacent to each other in the first direction (X direction), but the present invention is not limited thereto. The dummy area DA may mean an area at which a second portion 320 of the barrier pattern 300 to be described later is disposed. The dummy area DA may mean an area in which the barrier pattern 300 that will be described later is electrically connected to the source electrode 173.

In an embodiment, each area of the plurality of unit cell areas 130 excluding the dummy area DA may be the active area AA. The active area AA may mean an area in which the barrier pattern 300 to be described later is not disposed. The active area AA may be an area functioning as a transistor. For example, the active area AA may mean an area in which an electric current path is formed from the source electrode 173 toward the drain electrode 175 by the gate electrode 150 to be described later. For example, the drain electrode 175 may be electrically connected to the first conductivity type substrate 110 and the first conductivity type epitaxial layer 131. For example, the active area AA of the semiconductor device according to the embodiment may include an n-type field effect transistor (n-FET). However, the present invention is not limited thereto, and the active area AA may include a p-type field effect transistor.

The gate electrode 150 may be disposed within the gate trench 160 of the first conductivity type epitaxial layer 131. The gate electrode 150 may be separate from the first conductivity type epitaxial layer 131. The gate electrode 150 may be spaced apart from the first conductivity type epitaxial layer 131 at an almost constant interval, e.g., in the first direction (an X direction). However, the present invention is not limited thereto, and a separation distance between the gate electrode 150 and the first conductivity type epitaxial layer 131 may vary depending on a position. The gate electrode 150 may have a cross-sectional shape similar to that of the gate trench 160. The gate electrode 150 may include a lower surface and side surfaces extending from the lower surface, and the lower surface and the side surface of the gate electrode 150 may be formed in an approximately U-shaped cross section along a shape of the gate trench 160. The gate electrode 150 may further include an upper surface facing (i.e., opposite) the lower surface, and the side surfaces may connect the lower surface and the upper surface. The lower surface of the gate electrode 150 may face the bottom surface of the gate trench 160. The side surfaces of the gate electrode 150 may face inner side walls of the gate trench 160.

In an embodiment, a plurality of gate electrodes 150 may be provided. For example, the semiconductor device according to the embodiment may include the plurality of gate electrodes 150 disposed within the plurality of gate trenches 160. The plurality of gate electrodes 150 may extend in a direction parallel to the plurality of gate trenches 160. For example, the plurality of gate electrodes 150 may extend in the second direction (the Y direction). The plurality of gate electrodes 150 may be disposed to be spaced apart from each other along the first direction (the X direction).

The gate electrode 150 may include a conductive material. For example, the gate electrode 150 may include polysilicon doped with an impurity. As another example, the gate electrode 150 may include a metal, a metal alloy, conductive metal nitride, metal silicide, a doped semiconductor material, conductive metal oxide, conductive metal oxynitride, or a combination thereof. The gate electrode 150 may be made of a single layer or multiple layers.

The gate insulating layer 140 may be disposed between the first conductivity type epitaxial layer 131 and the gate electrode 150. For example, the gate insulating layer 140 may be disposed below (e.g., in the third direction (the Z direction)) the gate electrode 150, and may cover the lower surface of the gate electrode 150. The gate electrode 150 may be insulated from the first conductivity type epitaxial layer 131 by the gate insulating layer 140. The gate electrode 150 may be surrounded by the gate insulating layer 140.

The gate insulating layer 140 may be disposed on the bottom surface and a side wall of the gate trench 160. The gate insulating layer 140 may be disposed on the bottom surface and the side wall of the gate trench 160 with a substantially uniform thickness. Therefore, a distance between the gate electrode 150 and the first conductivity type epitaxial layer 131 may be almost constant.

The gate insulating layer 140 may include an insulating material. For example, the gate insulating layer 140 may include SiO₂. However, the present invention is not limited thereto, and a material of the gate insulating layer 140 may be variously changed. As another example, the gate insulating layer 140 may include SiN, SiON, SiC, SiCN, or a combination thereof. The gate insulating layer 140 may be made of a single layer or multiple layers.

The semiconductor device according to the embodiment may further include a capping layer 142 disposed on the gate electrode 150. The capping layer 142 may cover an upper surface of the gate electrode 150 (e.g., overlay the gate electrode 150). Additionally, the capping layer 142 may cover the gate insulating layer 140 adjacent to the gate electrode 150 and at least a portion of the first conductivity type doping layer 137 that will be described later (e.g., overlay a portion of the gate insulating layer 140 and/or the first conductivity type doping layer 137). The capping layer 142 may be disposed between source electrodes 173 to be described later. For example, the capping layer 142 may be disposed between source electrodes 173 adjacent to each other in the first direction (the X direction). The gate electrode 150 may be insulated from the source electrode 173 by the capping layer 142.

A thickness of the capping layer 142 along a third direction (a Z direction) may be almost constant. However, the present invention is not limited thereto, and the thickness of the capping layer 142 along the third direction (the Z direction) may gradually decrease from a central portion of the capping layer 142 to opposite edges thereof. The thickness of the capping layer 142 may be different from a thickness of the gate insulating layer 140. For example, the thickness of the capping layer 142 may be greater than the thickness of the gate insulating layer 140. In some embodiments, the thickness of the capping layer 142 may be similar to the thickness of the gate insulating layer 140.

The capping layer 142 may include an insulating material. For example, the capping layer 142 may include SiO₂, SiOP, SiN, SiON, or a combination thereof. However, the present invention is not limited thereto, and a material of the capping layer 142 may be variously changed. The capping layer 142 may be made of a single layer or multiple layers. The capping layer 142 may include the same material as that of the gate insulating layer 140, or may include a material different from that of the gate insulating layer 140. If the capping layer 142 is made of the same material as that of the gate insulating layer 140, a boundary between the capping layer 142 and the gate insulating layer 140 may not be clearly distinguished at a portion where the capping layer 142 and the gate insulating layer 140 are in contact with each other.

The source electrode 173 may be disposed above the first conductivity type epitaxial layer 131 (e.g., in the third direction (the Z direction)). The source electrode 173 may be disposed above an upper surface of the first conductivity type doping layer 137 and an upper surface of a second conductivity type doping layer 139 that will be described later.

The source electrode 173 may be disposed to be spaced apart from the gate trench 160. For example, the source electrode 173 may be disposed to be spaced apart from the gate trench 160 along the first direction (the X direction). For example, the source electrode 173 may not overlap the gate trench 160 and the gate electrode 150 in the third direction (the Z direction). The source electrode 173 may not overlay the gate trench 160 and the gate electrode 150 in the third direction (the Z direction).

The source electrode 173 may include a conductive material. For example, the source electrode 173 may include a metal, a metal alloy, conductive metal nitride, metal silicide, a doped semiconductor material, conductive metal oxide, conductive metal oxynitride, or the like. For example, the source electrode 173 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel-platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but the present invention is not limited thereto. The source electrode 173 may be made of a single layer or multiple layers.

The second conductivity type doping well 133 may be disposed on the first conductivity type epitaxial layer 131. The second conductivity type doping well 133 may be disposed between the first conductivity type epitaxial layer 131 and the source electrode 173. The second conductivity type doping well 133 may be disposed on a portion of the first conductivity type epitaxial layer 131 between the plurality of gate trenches 160. The second conductivity type doping well 133 may face the gate electrode 150 with the gate insulating layer 140 interposed therebetween.

The second conductivity type doping well 133 may be conformally disposed on the first conductivity type epitaxial layer 131. The second conductivity type doping well 133 may be an epitaxial layer formed from the first conductivity type epitaxial layer 131 using an epitaxial growth method. Alternatively, the second conductivity type doping well 133 may be a doping area formed using an ion implantation process within the first conductivity type epitaxial layer 131.

In some embodiments, the second conductivity type doping well (or second conductivity type doping well) 133 may be formed in (as part of) the first conductivity type epitaxial layer 131 such that impurities (charge carrier dopants) may be introduced into the epitaxial layer 131. Accordingly, the epitaxial layer 131 may not be materially distinctive from the second conductivity type doping well 133 to have a lack of material continuity. Reference to the epitaxial layer 131 being provided with the second conductivity type doping well 133 is referred to with the intention of encompassing these embodiments. The second conductivity type doping well 133 may accordingly be provided with the first conductivity type epitaxial layer 131. In other words, forming the second conductivity type doping well 133 from the first conductivity type epitaxial layer 131 using an epitaxial growth method (or the described ion implantation process) may occur with the first conductivity type epitaxial layer 131.

In an embodiment, at least a portion of the second conductivity type doping well 133 may be disposed on the barrier pattern 300 to be described later. For example, as illustrated in FIG. 4, the barrier pattern 300 may be disposed on the first conductivity type epitaxial layer 131 between the plurality of gate trenches 160, and the second conductivity type doping well 133 may be disposed on the barrier pattern 300 disposed between the plurality of gate trenches 160. A portion of a lower surface of the second conductivity type doping well 133 may be in contact with the barrier pattern 300, but the present invention is not limited thereto. A detailed description thereof will be given later in a description of the barrier pattern 300. At least a portion of the barrier pattern 300 may be disposed between the second conductivity type doping well 133 and the first conductivity type epitaxial layer 131.

The second conductivity type doping well 133 may include SiC. For example, the second conductivity type doping well 133 may include 4H SiC. The second conductivity type doping well 133 may be doped with a p-type impurity. The second conductivity type doping well 133 may be doped with a p-type impurity with a low concentration. A doping concentration of the second conductivity type doping well 133 may be about 1*10¹⁷cm⁻³ or more and about 1 * 10¹⁹ cm⁻³ or less. A thickness of the second conductivity type doping well 133 may be about 0.3 µm or more and about 1.1 µm or less, but the present invention is not limited thereto. A material, a doping type, a doping concentration, a thickness, and the like of the second conductivity type doping well 133 are not limited thereto, and may be variously changed.

The first conductivity type doping layer 137 may be disposed on the first conductivity type epitaxial layer 131. The first conductivity type doping layer 137 may be disposed on the second conductivity type doping well 133. The first conductivity type doping layer 137 may be disposed at least partially between the second conductivity type doping well 133 and the source electrode 173. One surface of the first conductivity type doping layer 137 may be in contact with the second conductivity type doping well 133, and at least a portion the other surface of the first conductivity type doping layer 137 may be in contact with a metal silicide layer 191 (or the source electrode 173).

Portions of the first conductivity type doping layer 137 may be separated from each other by the gate trench 160. For example, portions of the first conductivity type doping layer 137 may be separate from each other in the first direction (the X direction) by the gate trench 160. For example, portions of the first conductivity type doping layer 137 may be disposed to be spaced apart from each other along the first direction (the X direction) by the gate trench 160.

Accordingly, the first conductivity type doping layer 137 may be disposed on opposite sides of the gate trench 160. For example, as shown in FIG. 3 and FIG. 4, the first conductivity type doping layer 137 may be disposed on opposite sides of the gate trench 160 along the first direction (the X direction). The first conductivity type doping layer 137 may not overlap or overlay the gate trench 160 in the third direction (the Z direction). The first conductivity type doping layer 137 may not cover the gate trench 160. In other words, the first conductivity type doping layer 137 may cover, overlay, or overlap the first conductivity type epitaxial layer 131 without covering, overlaying, or overlapping the gate trench 160.

The first conductivity type doping layer 137 may face the gate electrode 150 with the gate insulating layer 140 interposed therebetween. A surface of the first conductivity type doping layer 137 facing the gate electrode 150 may be disposed on the same boundary line as a side wall of the gate trench 160. At least a portion of an upper surface of the first conductivity type doping layer 137 may be in contact with the metal silicide layer 191 to be described later, and a lower surface of the first conductivity type doping layer 137 may be in contact with the second conductivity type doping well 133. The source electrode 173 and the metal silicide layer 191 may be in ohmic contact with the first conductivity type doping layer 137. An area in contact with the metal silicide layer 191 within the first conductivity type doping layer 137 may be doped at a relatively high concentration compared with another area. However, the present invention is not limited thereto, and another predetermined layer may be disposed between the first conductivity type doping layer 137 and the source electrode 173. At least a portion of the upper surface of the first conductivity type doping layer 137 may be covered by the capping layer 142, but the present invention is not limited thereto.

The first conductivity type doping layer 137 may be a doping area formed using an ion implantation process within the second conductivity type doping well 133. The first conductivity type doping layer 137 may include SiC. For example, the first conductivity type doping layer 137 may include 4H SiC. The first conductivity type doping layer 137 may be doped with an n-type impurity. The first conductivity type doping layer 137 may be doped with an n-type impurity with a high concentration. A doping concentration of the first conductivity type doping layer 137 may be about 1*10¹⁸ cm⁻³ or more and about 5*10²⁰ cm⁻³ or less. A thickness of the first conductivity type doping layer 137 may be about 0.1 µm or more and about 0.5 µm or less. A material, a doping type, a doping concentration, and the like of the first conductivity type doping layer 137 are not limited thereto, and may be variously changed.

In some embodiments, the first conductivity type doping layer 137 may be formed in (as part of) the first conductivity type epitaxial layer 131 such that impurities may be introduced into the epitaxial layer 131. Accordingly, the epitaxial layer 131 may not be materially distinctive from the first conductivity type doping layer 137 to have a lack of material continuity. Reference to the epitaxial layer 131 being provided with the first conductivity type doping layer 137 is referred to with the intention of encompassing these embodiments.

The second conductivity type doping layer 139 may be disposed on the second conductivity type doping well 133. The second conductivity type doping layer 139 may be disposed between the second conductivity type doping well 133 and the source electrode 173 (e.g., in the third direction (Z direction)).

In an embodiment, the second conductivity type doping layer 139 may be disposed on one side of the first conductivity type doping layer 137. For example, the second conductivity type doping layer 139 may be disposed on one side of the first conductivity type doping layer 137 along the first direction (the X direction). For example, the first conductivity type doping layer 137 may be disposed between the second conductivity type doping layer 139 and the gate electrode 150 including the gate insulating layer 140. The second conductivity type doping layer 139 may be disposed to be spaced apart from the gate trench 160 in the first direction (the X direction). The second conductivity type doping layer 139 may be disposed to be spaced apart from the gate insulating layer 140 in the first direction (the X direction).

The second conductivity type doping layer 139 may be disposed at the same layer as that of the first conductivity type doping layer 137. An upper surface of the second conductivity type doping layer 139 may be disposed at substantially the same level as that of the upper surface of the first conductivity type doping layer 137. For example, the upper surface of the second conductivity type doping layer 139 may be disposed at substantially the same distance from the upper surface of the first conductivity type doping layer 137 and an upper surface of the first conductivity type substrate 110. A lower surface of the second conductivity type doping layer 139 may be disposed at a lower level than that of a lower surface of the first conductivity type doping layer 137, but the present invention is not limited thereto. For example, the lower surface of the second conductivity type doping layer 139 may be disposed closer to the upper surface of the first conductivity type substrate 110 than the lower surface of the first conductivity type doping layer 137, but the present invention is not limited thereto.

The second conductivity type doping layer 139 may be a doping area formed using an ion implantation process within the first conductivity type epitaxial layer 131. The second conductivity type doping layer 139 may include SiC. For example, the second conductivity type doping layer 139 may include 4H SiC. The second conductivity type doping layer 139 may be doped with a p-type impurity. The second conductivity type doping layer 139 may be doped with a p-type impurity with a high concentration. A doping concentration of the second conductivity type doping layer 139 may be about 1*10¹⁸ cm⁻³ or more and about 5*10²⁰ cm⁻³ or less. A material, a doping type, a doping concentration, and the like of the second conductivity type doping layer 139 are not limited thereto, and may be variously changed.

In some embodiments, the second conductivity type doping layer 139 may be formed in (as part of) the first conductivity type epitaxial layer 131 such that impurities may be introduced into the epitaxial layer 131. Accordingly, the epitaxial layer 131 may not be materially distinctive from the second conductivity type doping layer 139 to have a lack of material continuity. Reference to the epitaxial layer 131 being provided with the second conductivity type doping layer 139 is referred to with the intention of encompassing these embodiments.

The semiconductor device according to the embodiment may further include the metal silicide layer 191 disposed between the source electrode 173 and the second conductivity type doping well 133. For example, the metal silicide layer 191 may be disposed between the first conductivity type doping layer 137 and the source electrode 173 and between the second conductivity type doping layer 139 and the source electrode 173. The first conductivity type doping layer 137 and the source electrode 173 and the second conductivity type doping layer 139 and the source electrode 173 may be electrically and smoothly connected by the metal silicide layer 191. Additionally, as illustrated in FIG. 4, the metal silicide layer 191 may be in contact with the second conductivity type doping well 133 and the source electrode 173, but the present invention is not limited thereto. The metal silicide layer 191 may overlay a portion of the first conductivity type doping layer 137, e.g., in the third direction (Z direction). The metal silicide layer 191 may overlay the second conductivity type doping layer 139, e.g., in the third direction (Z direction).

The drain electrode 175 may be disposed on the second surface (e.g., a lower surface) of the first conductivity type substrate 110. An upper surface of the drain electrode 175 may be in contact with the lower surface of the first conductivity type substrate 110. The drain electrode 175 may be in ohmic contact with the first conductivity type substrate 110. An area in contact with the drain electrode 175 within the first conductivity type substrate 110 may be doped at a relatively high concentration compared with another area. However, the present invention is not limited thereto, and another predetermined layer may be disposed between the drain electrode 175 and the first conductivity type substrate 110. For example, a silicide layer may be disposed between the drain electrode 175 and the first conductivity type substrate 110. The drain electrode 175 and the first conductivity type substrate 110 may be electrically and smoothly connected by the silicide layer.

The drain electrode 175 may include a conductive material. For example, the drain electrode 175 may include a metal, a metal alloy, conductive metal nitride, metal silicide, a doped semiconductor material, conductive metal oxide, conductive metal oxynitride, or the like. The drain electrode 175 may be made of the same material as that of the source electrode 173, or may be made of a material different from that of the source electrode 173. The drain electrode 175 may be made of a single layer or multiple layers.

The barrier pattern 300 may be disposed on the first conductivity type epitaxial layer 131. The barrier pattern 300 may be disposed between the first conductivity type epitaxial layer 131 and the gate electrode 150, and between the first conductivity type epitaxial layer 131 and the second conductivity type doping well 133. The barrier pattern 300 may be disposed at the dummy area DA, and may not be disposed at the plurality of unit cell areas 130. The barrier pattern 300 may not overlap or overlay the first conductivity type doping layer 137 and the second conductivity type doping layer 139 in the third direction (the Z direction). The barrier pattern 300 may be electrically connected to the source electrode 173 through the second conductivity type doping well 133.

The barrier pattern 300 may be a doping area formed using an ion implantation process within the first conductivity type epitaxial layer 131. The barrier pattern 300 may include SiC. For example, the barrier pattern 300 may include 4H SiC. The barrier pattern 300 may have the same conductivity type as those of the second conductivity type doping well 133 and the second conductivity type doping layer 139. For example, the barrier pattern 300 may be doped with a p-type impurity. In this case, a doping concentration of the barrier pattern 300 may be greater than or equal to a doping concentration of the second conductivity type doping well 133, but the present invention is not limited thereto. Within this range, the barrier pattern 300 may effectively alleviate an electric field generated around the gate electrode 150. The barrier pattern 300 may operate to alleviate an electric field. In some embodiments, the barrier pattern 300 may be made of a single layer or multiple layers. Here, the doping concentration of the barrier pattern 300 and the doping concentration of the second conductivity type doping well 133 may refer to the average concentration and/or the maximum concentration in each region. The doping concentration of the barrier pattern 300 and the doping concentration of the second conductivity type doping well 133 may each have a different profile depending on the location. Therefore, even if the doping concentration of the barrier pattern 300 and the doping concentration of the second conductivity type doping well 133 are the same, the barrier pattern 300 and the second conductivity type doping well 133 may have different concentrations in some parts adjacent to each other, and the boundary between the barrier pattern 300 and the second conductivity type doping well 133 may be recognized.

In some embodiments, the barrier pattern 300 may be formed in (as part of) the first conductivity type epitaxial layer 131 such that impurities may be introduced into the epitaxial layer 131. Accordingly, the epitaxial layer 131 may not be materially distinctive from the barrier pattern 300 to have a lack of material continuity. Reference to the epitaxial layer 131 being provided with the barrier pattern 300 is referred to with the intention of encompassing these embodiments.

The barrier pattern 300 of the semiconductor device according to the embodiment may include a first portion 310 disposed on a lower surface of the gate trench 160 and the second portion 320 disposed between the first conductivity type epitaxial layer 131 and the second conductivity type doping well 133. The first portion 310 may be disposed on a lower surface outside of the gate trench 160. In other words, the first portion 310 may be outside (not inside) the gate trench 160.

The first portion 310 may be disposed on the first conductivity type epitaxial layer 131. The first portion 310 may be disposed below the gate trench 160. For example, the first portion 310 may be disposed on the lower surface of the gate trench 160. The first portion 310 may be disposed below the gate electrode 150 disposed within the gate trench 160. The gate insulating layer 140 may be disposed between the gate electrode 150 and the first portion 310. An upper surface of the first portion 310 may be in contact with the gate insulating layer 140. Additionally, the first portion 310 may overlap or overlay the gate electrode 150 in the third direction (the Z direction). The first portion 310 may completely overlap the gate electrode 150 in the third direction (the Z direction), but the present invention is not limited thereto. The first portion 310 may not overlap the source electrode 173 and the second conductivity type doping well 133 in the third direction (the Z direction). Additionally, the first portion 310 may not overlap the first conductivity type doping layer 137 and the second conductivity type doping layer 139 in the third direction (the Z direction). The first portion 310 may be disposed between the gate insulating layer 140 and the first conductivity type epitaxial layer 131. While the first portion 310 is described as overlapping or overlaying the gate electrode 150 in the third direction (the Z direction), depending on perspective, the gate electrode 150 may be described as overlapping or overlaying the first portion 310. The gate electrode 150 may completely overlap or overlay the first portion 310. The first portion 310 may only be overlaid or overlapped by the gate electrode 150 (and gate insulating layer 140), without any portion of the first portion 310 being overlaid or overlapped by the first conductivity type doping layer 137, source electrode 173, or second conductivity type doping layer 139.

The first portion 310 may extend in a direction parallel to the gate trench 160. The first portion 310 may extend in a direction parallel to the gate electrode 150. For example, the first portion 310 may extend in the second direction (the Y direction).

In an embodiment, a plurality of first portions 310 may be provided. For example, the plurality of first portions 310 may be disposed below the gate tranches 160 spaced apart from each other along the first direction (the X direction). The plurality of first portions 310 may be disposed below gate electrodes 150 disposed spaced apart from each other along the first direction (the X direction). The plurality of first portions 310 may extend in the second direction (the Y direction) to be disposed spaced apart from each other along the first direction (the X direction). The plurality of first portions 310 may be connected to each other by the second portion 320 to be described later, but the present invention is not limited thereto.

A first width W1 of the first portion 310 along the first direction (the X direction) may be smaller than or equal to a second width W2 of the gate trench 160 along the first direction (the X direction). The first width W1 of the first portion 310 along the first direction (the X direction) may be smaller than or equal to a third width W3 of the gate electrode 150 along the first direction (the X direction). Within this range, the first portion 310 may effectively alleviate an electric field generated around the gate electrode 150, and at the same time, it may sufficiently secure an area of the active area AA where the electric current path is formed from the source electrode 173 toward the drain electrode 175 by the gate electrode 150.

The second portion 320 may be disposed on the first conductivity type epitaxial layer 131. The second portion 320 may be disposed on a lower surface of the second conductivity type doping well 133. For example, the second portion 320 may be disposed on the lower surface of the second conductivity type doping well 133 disposed at the dummy area DA. The second portion 320 may be disposed between the first conductivity type epitaxial layer 131 and the second conductivity type doping well 133. The second portion 320 may overlap or overlay the second conductivity type doping well 133 in the third direction (the Z direction). An upper surface of the second portion 320 may be in contact with the second conductivity type doping well 133, but the present invention is not limited thereto. Accordingly, the second portion 320 may be electrically connected to the source electrode 173 through the second conductivity type doping well 133. While the second portion 320 is described as overlapping or overlaying the second conductivity type doping well 133 in the third direction (the Z direction), depending on perspective, the second portion 320 may be described as overlapping or overlaying the second conductivity type doping well 133 in the third direction (the Z direction). The gate electrode 150 (and gate insulating layer 140) may overlay or overlap the second portion 320 in the third direction (the Z direction).

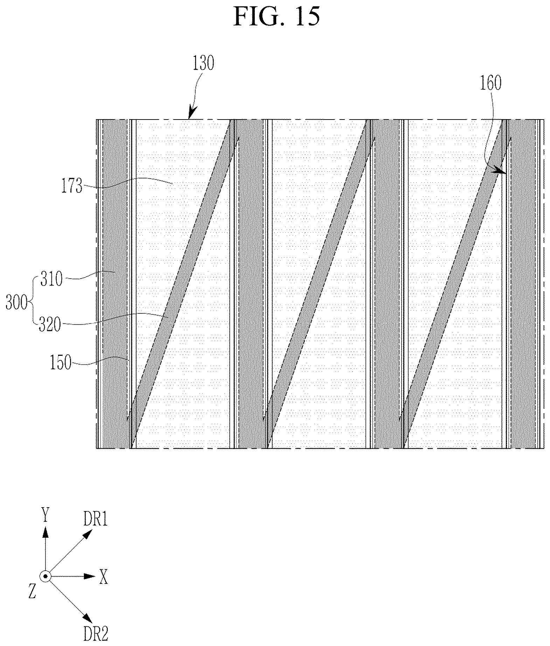

The second portion 320 may extend from one end of the first portion 310. In this case, the second portion 320 may extend in a direction different from a direction in which the first portion 310 extends. For example, as illustrated in FIG. 1 and FIG. 2, The first and second portions 310 and 320 may be elongated in different directions from each other (e.g., the largest dimension of the first and second portions 310 and 320 may be elongated in different directions from each other). The first portion 310 may extend in the second direction (the Y direction), and the second portion 320 may extend along the first direction (the X direction) from the one end of the first portion 310. The first and second portions 310, 320 may extend in perpendicular directions. The second portion extends lengthwise in the first direction (the X direction). Accordingly, at least a portion of the second portion 320 may not overlap the gate electrode 150 in the third direction (the Z direction), and may overlap the source electrode 173 in the third direction (the Z direction). However, the present invention is not limited thereto, and the second portion 320 may extend in various directions. A description thereof will be provided later with reference to the drawings including FIG. 15.

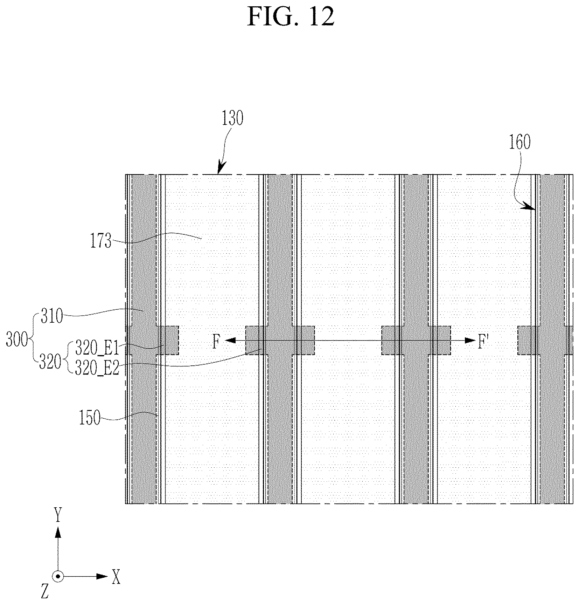

The second portion 320 may be disposed between the plurality of first portions 310 that are disposed spaced apart from each other along the first direction (the X direction). In an embodiment, the second portion 320 may connect the plurality of first portions 310 disposed adjacent to each other along the first direction (the X direction). For example, the second portion 320 may extend in the first direction (the X direction) to be integrally formed with the plurality of first portions 310 disposed adjacent to each other along the first direction (the X direction). Accordingly, the plurality of first portions 310 may be electrically and physically connected to each other by the second portion 320. For example, the semiconductor device further includes a plurality of additional gate electrodes(i.e., a plurality of gate electrodes 150) that extend in the second direction (the Y direction), and a plurality of additional first portions(i.e., a plurality of first portions 310) disposed below the plurality of additional gate electrodes. the plurality of additional gate electrodes and the gate electrode 150 are disposed spaced apart from each other in the first direction (the X direction), and the second portion 320 connects the plurality of additional first portions and the first portion 310. The plurality of additional first portions and the first portion 310 extend in the second direction (the Y direction) and are disposed spaced apart from each other in first direction (the X direction). However, the present invention is not limited thereto, and the second portion 320 may not connect the plurality of first portions 310 disposed adjacent to each other along the first direction (the X direction). A description thereof will be given later with reference to FIGS. 12 to 14.

The second portion 320 may surround at least a portion of the gate trench 160. For example, the second portion 320 may surround the lower surface of the gate trench 160 and at least a portion of the side wall of the gate trench 160. The second portion 320 may be in contact with the gate insulating layer 140, but the present invention is not limited thereto. A lower surface 320_B of the second portion 320 may be disposed at a relatively lower level (in the third direction, e.g., Z direction) than that of the lower surface of the gate trench 160. The lower surface 320_B of the second portion 320 may be disposed closer to an upper surface of the first conductivity type substrate 110 than the lower surface of the gate trench 160. An upper surface of the second portion 320 may be disposed farther from the upper surface of the first conductivity type substrate 110 than an upper surface of the first portion 310.

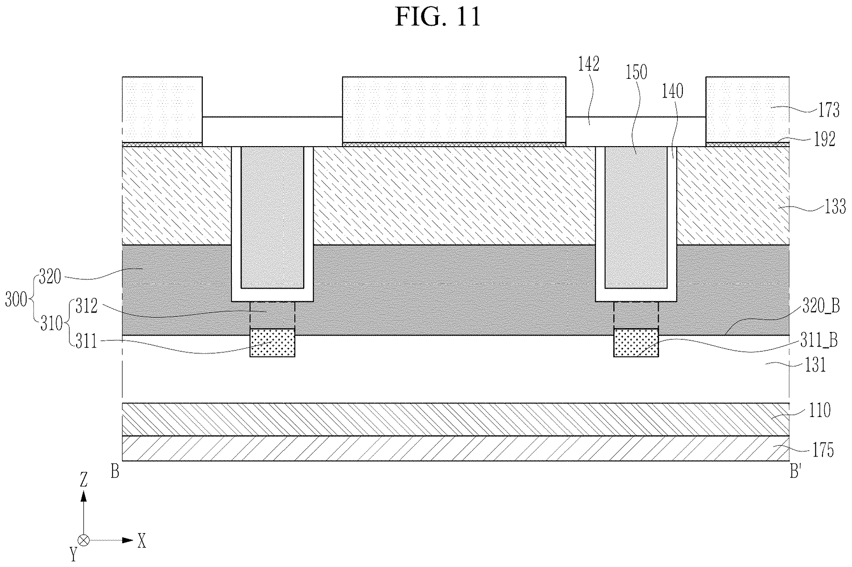

In an embodiment, the lower surface 320_B of the second portion 320 may be disposed at substantially the same level as that of a lower surface 310_B of the first portion 310. The lower surface 320_B of the second portion 320 may be disposed at substantially the same distance from the lower surface 310_B of the first portion 310 and the upper surface of the first conductivity type substrate 110. This may be due to a characteristic of a process in which the gate trench 160 from which at least a portion of the first portion 310 is removed is formed after the first portion 310 and the second portion 320 are first formed to have substantially the same depth. For example, the first portion 310 and the second portion 320 may be simultaneously formed in a single process, so that a process of manufacturing the semiconductor device according to the embodiment is simplified. However, the present invention is not limited thereto, and the lower surface 320_B of the second portion 320 and the lower surface 310_B of the first portion 310 may be disposed at different levels. A description thereof will be given later with reference to FIG. 11.

The second portion 320 may be integrally formed with the first portion 310. The second portion 320 may include the same material as that of the first portion 310. The second portion 320 may be simultaneously formed with the first portion 310 by the same process. Because the second portion 320 is integrally formed with the first portion 310, a boundary between the second portion 320 and the first portion 310 may not be visually recognized, but the present invention is not limited thereto.

In the semiconductor device according to the embodiment, if a turn-on signal is applied to the gate electrode 150, an electric current may flow in the third direction (the Z direction) from the source electrode 173 disposed at the active area AA toward the drain electrode 175. In this case, the electric current may reach the drain electrode 175 from the source electrode 173 through the first conductivity type doping layer 137, the second conductivity type doping well 133, the first conductivity type epitaxial layer 131, and the first conductivity type substrate 110. In this case, if the turn-on signal is applied to the gate electrode 150, an electric field may be generated around the gate electrode 150.

The barrier pattern 300 of the semiconductor device according to the embodiment may include the first portion 310 disposed below the gate electrode 150. In this case, the first width W1 of the first portion 310 along the first direction (the X direction) may be less than or equal to a third (may be referred to as a second) width W3 of the gate electrode 150 along the first direction (the X direction). Accordingly, the barrier pattern 300 may alleviate an electric field generated around the gate electrode 150 within a range in which the third width W3 of the gate electrode 150 along the first direction (the X direction) is not increased. For example, reliability of the semiconductor device according to the embodiment may be improved while an increase in a distance between adjacent plurality of unit cell areas 130 is prevented.

Because the first width W1 of the first portion 310 along the first direction (the X direction) is less than or equal to the third width W3 of the gate electrode 150 along the first direction (the X direction), a sufficient space for electrically connecting the first portion 310 to the source electrode 173 may not be secured. The barrier pattern 300 of the semiconductor device according to the embodiment may include the second portion 320 for being electrically connected to the source electrode 173. The second portion 320 may extend in a direction different from an extending direction of the first portion 310. For example, the first portion 310 may extend in the second direction (the Y direction), and the second portion 320 may extend in the first direction (the X direction). The gate electrode 150 may extend in the second direction (the Y direction) similar to the first portion 310. A central axis along a major longitudinal length of the first portion 310 may be aligned with a central axis along a major longitudinal length of the gate electrode 150. The gate electrode 150 and first portion 310 may be aligned in the second direction (the Y direction). Accordingly, at least a portion of the second portion 320 may not overlap the gate electrode 150 in the third direction (the Z direction), and may overlap the source electrode 173 in the third direction (the Z direction). At least a portion of the gate electrode 150 may not overlay or overlay the second portion 320 in the third direction (the Z direction). At least a portion of the source electrode 173 may overlap or overlay the second portion 320 in the third direction (the Z direction). The second portion 320 may be electrically connected to the source electrode 173 through the second conductivity type doping well 133. Accordingly, a voltage (e.g., a ground voltage) applied from the source electrode 173 may be applied to the barrier pattern 300 of the semiconductor device according to the embodiment, and the barrier pattern 300 may effectively alleviate an electric field generated around the gate electrode 150 while an increase in a distance between adjacent plurality of unit cell areas 130 is prevented. Therefore, reliability of the semiconductor device according to the embodiment may be improved, and/or degree of integration of the semiconductor device may be improved.

The semiconductor device according to the embodiment may be a semiconductor transistor, e.g., an n-type field effect transistor (n-FET). However, the present invention is not limited thereto, and the semiconductor device according to the embodiment may be a p-type field effect transistor (p-FET). In this case, each of the first conductivity type substrate 110, the first conductivity type epitaxial layer 131, and the first conductivity type doping layer 137 may be doped with a p-type impurity, and each of the second conductivity type doping well 133 and the barrier pattern 300 may be doped with an n-type impurity.

Although the semiconductor device according to the embodiment has been described as having a structure in which the gate electrode 150 is disposed within the gate trench 160 and the source electrode 173 is disposed at a layer higher than that of the gate electrode 150, the present invention is not limited thereto. For example, in a semiconductor device according to some embodiments, the gate electrode 150 may be disposed within the gate trench 160, and the source electrode 173 may be disposed within a source trench disposed at one side of the gate trench 160. As another example, in a semiconductor device according to some embodiments, the gate electrode 150 may be disposed above an upper surface of the first conductivity type epitaxial layer 131, and the source electrode 173 may be disposed between the gate electrodes 150 above the first conductivity type epitaxial layer 131. As another example, a semiconductor device according to some embodiments may include a Si insulated gate bipolar transistor (IGBT) structure. As another example, a semiconductor device according to some embodiments may include a superjunction structure in which a p-type area and an n-type area are completely depleted so that an electric field distribution is uniformly formed in two dimensions. The barrier pattern 300 according to the embodiment of FIGS. 1 to 5 may be included in the embodiments.

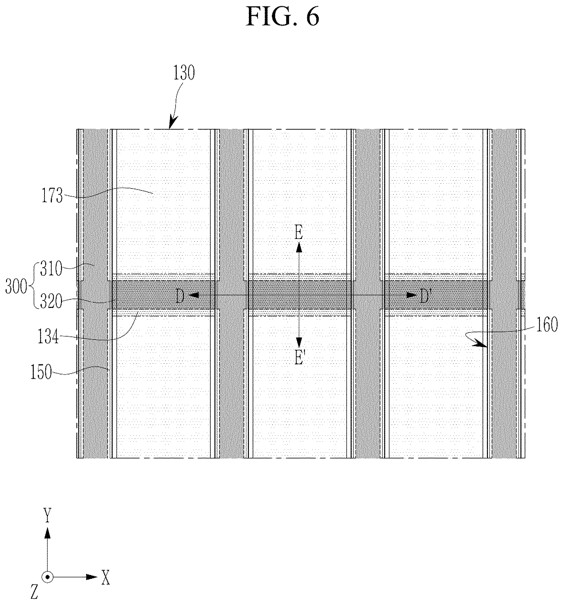

Hereinafter, a semiconductor device according to some embodiments will be described with reference to FIGS. 6 to 8. The description provided with reference to FIGS. 1 to 5 is applicable to the remaining plurality of items unless context indicates otherwise.

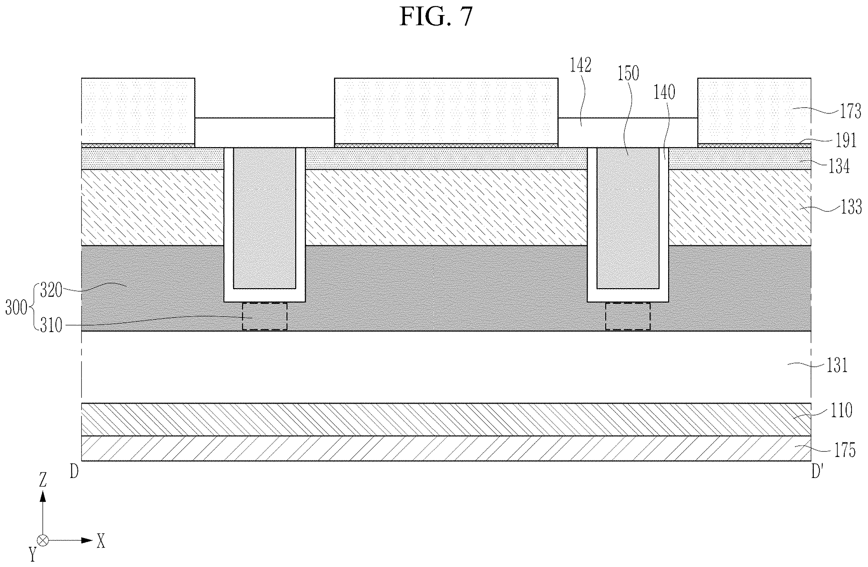

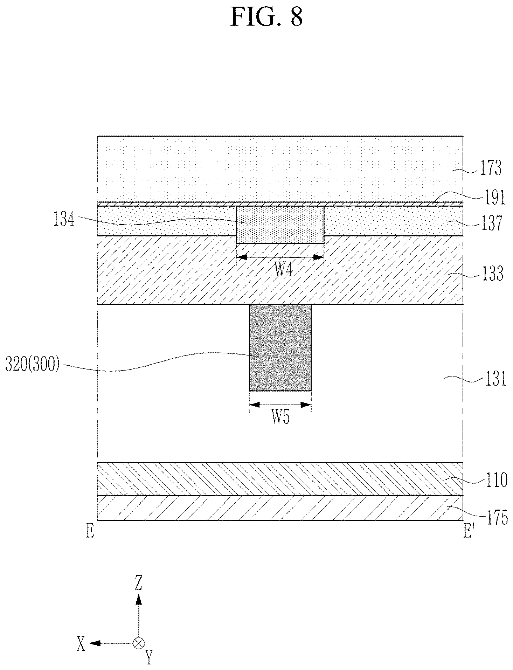

FIG. 6 is a plan view showing the semiconductor device according to some embodiments. FIG. 7 is a cross-sectional view cut along a line D-D' of FIG. 6. FIG. 8 is a cross-sectional view cut along a line E-E' of FIG. 6.

FIGS. 6 to 8 illustrate various modified examples of the semiconductor device according to the embodiment illustrated in FIGS. 1 to 5. Because the embodiment shown in FIGS. 6 to 8 has the same portion as that of the embodiment shown in FIGS. 1 to 5, a description thereof will be omitted and a difference between the embodiment shown in FIGS. 6 to 8 and the embodiment shown in FIGS. 1 to 5 will be mainly described. Additionally, the same reference numeral is used for a component that is the same as that of the previous embodiment. The embodiment shown in FIGS. 6 to 8 may be partially different from the previous embodiment in that a second conductivity type doping pattern 134 is further included between the second conductivity type doping well 133 and the source electrode 173.

Referring to FIGS. 6 to 8, the semiconductor device according to some embodiments may further include the second conductivity type doping pattern 134 between the second conductivity type doping well 133 and the source electrode 173.

The second conductivity type doping pattern 134 may be disposed on the second conductivity type doping well 133. The second conductivity type doping pattern 134 may be disposed above the second portion 320 of the barrier pattern 300. The second conductivity type doping pattern 134 may be disposed on the second conductivity type doping well 133 that overlaps the second portion 320 of the barrier pattern 300 in the third direction (the Z direction). The second conductivity type doping pattern 134 may be disposed between the plurality of gate trenches 160 disposed adjacent to each other in the first direction (the X direction). For example, the second conductivity type doping pattern 134 may be disposed between the plurality of gate electrodes 150 disposed adjacent to each other in the first direction (the X direction). The second conductivity type doping pattern 134 may not overlap the gate electrode 150 in the third direction (the Z direction). The second conductivity type doping pattern 134 may be electrically connected to the source electrode 173. The second portion 320 of the barrier pattern 300 may be electrically connected to the source electrode 173 by the second conductivity type doping pattern 134.

In some embodiments, the second conductivity type doping pattern 134 may extend in the same direction as that of the second portion 320. For example, the second conductivity type doping pattern 134 may extend in the first direction (the X direction). The second conductivity type doping pattern 134 may overlap or overlay the second portion 320 in the third direction (the Z direction), and may not overlap or overlay the first portion 310 in the third direction (the Z direction). In this case, as illustrated in FIG. 8, a fourth width W4 of the second conductivity type doping pattern 134 along the second direction (the Y direction) may be greater than or equal to a fifth width W5 of the second portion 320 along the second direction (the Y direction). Accordingly, the second portion 320 may not overlap or overlay the first conductivity type doping layer 137 in the third direction (the Z direction). The first conductivity type doping layer 137 may not overlay or overlay the second portion 320 in the third direction (the Z direction). The second conductivity type doping pattern 134 may be doped with the same conductivity type as that of the barrier pattern 300. For example, the second conductivity type doping pattern 134 may be doped with a p-type impurity. A doping concentration of the second conductivity type doping pattern 134 may be less than or equal to a doping concentration of the barrier pattern 300. Within this range, the barrier pattern 300 may effectively alleviate an electric field generated around the gate electrode 150.

In some embodiments, the second conductivity type doping pattern (or second conductivity type doping region) 134 may be formed in (as part of) the first conductivity type epitaxial layer 131 such that impurities may be introduced into the epitaxial layer 131. Accordingly, the epitaxial layer 131 may not be materially distinctive from the second conductivity type doping pattern 134 to have a lack of material continuity. Reference to the epitaxial layer 131 being provided with the second conductivity type doping pattern 134 is referred to with the intention of encompassing these embodiments.

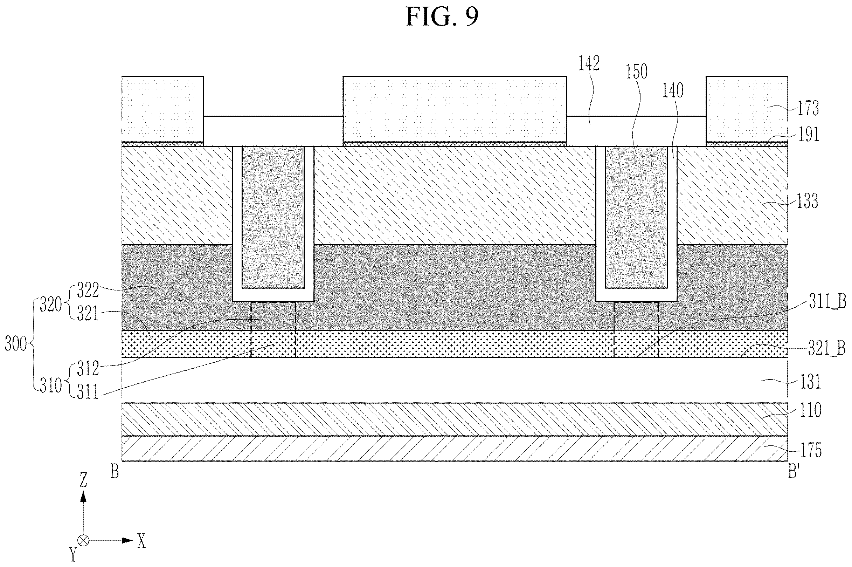

Hereinafter, a semiconductor device according to some embodiments will be described with reference to FIGS. 9 to 10. The description provided with reference to FIGS. 1 to 8 is applicable to the remaining plurality of items unless context indicates otherwise.

Each of FIGS. 9 to 11 is a cross-sectional view corresponding to the line B-B' of FIG. 1 showing a semiconductor device according to some embodiments.

FIGS. 9 to 11 illustrate various modified examples of the semiconductor device according to the embodiment illustrated in FIGS. 1 to 5. Because the embodiment shown in FIGS. 9 to 11 has the same portion as that of the embodiment shown in FIGS. 1 to 5, a description thereof will be omitted and a difference between the embodiment shown in FIGS. 9 to 11 and the embodiment shown in FIGS. 1 to 5 will be mainly described. Additionally, the same reference numeral is used for a component that is the same as that of the previous embodiment.

Referring to FIGS. 9 to 11, the barrier pattern 300 of the semiconductor device according to some embodiments may be formed of multiple layers. For example, the first portion 310 and/or the second portion 320 of the barrier pattern 300 may be formed of the multiple layers.

Referring to FIG. 9, for example, the first portion 310 and the second portion 320 of the barrier pattern 300 may be formed of multiple layers. The first portion 310 may include a first pattern portion 311 disposed between the first conductivity type epitaxial layer 131 and the gate trench 160 and a second pattern portion 312 disposed between the first pattern portion 311 and the gate trench 160. Each of the first pattern portion 311 and the second pattern portion 312 may extend in the second direction (the Y direction). A width of the second pattern portion 312 along the first direction (the X direction) may be substantially the same as a width of the first pattern portion 311 along the first direction (the X direction), but the present invention is not limited thereto. As another example, a width of the second pattern portion 312 along the first direction (the X direction) may be smaller than or equal to a width of the first pattern portion 311 along the first direction (the X direction).

The first pattern portion 311 and the second pattern portion 312 may be doped with the same conductivity type. For example, the first pattern portion 311 and the second pattern portion 312 may be doped with a p-type impurity. The first pattern portion 311 and the second pattern portion 312 may be doped with different concentrations, but the present invention is not limited thereto. However, even in this case, each of a doping concentration of the first pattern portion 311 and a doping concentration of the second pattern portion 312 may be greater than or equal to a doping concentration of the second conductivity type doping well 133. Additionally, each of a doping concentration of the first pattern portion 311 and a doping concentration of the second pattern portion 312 may be greater than or equal to a doping concentration of the first conductivity type epitaxial layer 131.

The second portion 320 may include a third pattern portion 321 disposed between the first conductivity type epitaxial layer 131 and the second conductivity type doping well 133, and a fourth pattern portion 322 disposed between the third pattern portion 321 and the second conductivity type doping well 133. Each of the third pattern portion 321 and the fourth pattern portion 322 may extend in the first direction (the X direction), but the present invention is not limited thereto.

In some embodiments, the third pattern portion 321 may be disposed at the same layer as that of the first pattern portion 311. The third pattern portion 321 may be integrally formed with the first pattern portion 311. The third pattern portion 321 may include the same material as that of the first pattern portion 311, but the present invention is not limited thereto. In some embodiments, a lower surface 321_B of the third pattern portion 321 may be disposed at substantially the same level as that of a lower surface 311_B of the first pattern portion 311. For example, the lower surface 321_B of the third pattern portion 321 may be disposed at substantially the same distance from the lower surface 311_B of the first pattern portion 311 and an upper surface of the first conductivity type substrate 110. However, the present invention is not limited thereto, and the lower surface 321_B of the third pattern portion 321 may be disposed at a different level from that of the lower surface 311_B of the first pattern portion 311. Additionally, the fourth pattern portion 322 may be disposed at the same layer as that of the second pattern portion 312. The fourth pattern portion 322 may be integrally formed with the second pattern portion 312. The fourth pattern portion 322 may include the same material as that of the second pattern portion 312, but the present invention is not limited thereto.

The third pattern portion 321 and the fourth pattern portion 322 may be doped with the same conductivity type. For example, the third pattern portion 321 and the fourth pattern portion 322 may be doped with a p-type impurity. The third pattern portion 321 and the fourth pattern portion 322 may be doped with different concentrations, but the present invention is not limited thereto. However, even in this case, each of a doping concentration of the third pattern portion 321 and a doping concentration of the fourth pattern portion 322 may be greater than or equal to a doping concentration of the second conductivity type doping well 133. Additionally, each of the doping concentration of the third pattern portion 321 and the doping concentration of the fourth pattern portion 322 may be greater than or equal to the doping concentration of the first conductivity type epitaxial layer 131.

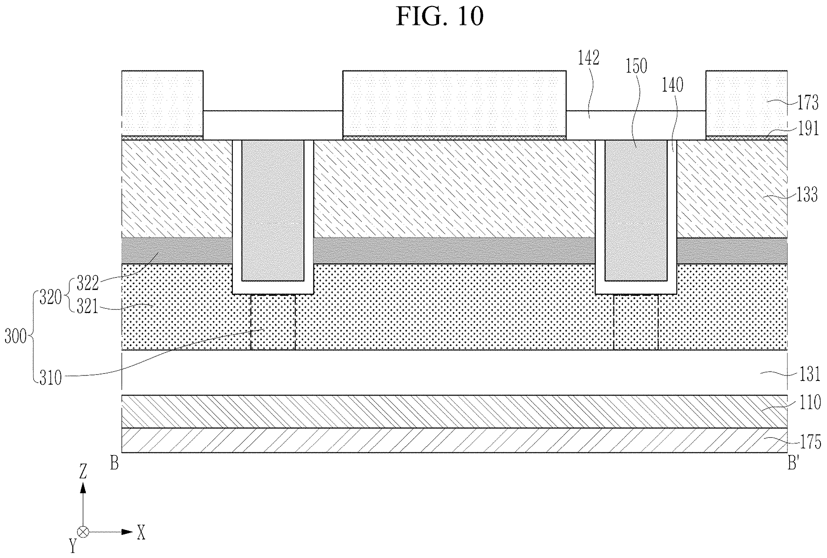

Referring to FIG. 10, as another example, the first portion 310 of the barrier pattern 300 may be formed of a single layer, and the second portion 320 may be formed of multiple layers.

As described in FIG. 9, the second portion 320 may include the third pattern portion 321 disposed between the first conductivity type epitaxial layer 131 and the second conductivity type doping well 133, and the fourth pattern portion 322 disposed between the third pattern portion 321 and the second conductivity type doping well 133. In this case, the first portion 310 of the barrier pattern 300 may be integrally formed with the third pattern portion 321. The first portion 310 may include the same material as that of the third pattern portion 321. In this case, a lower surface of the third pattern portion 321 may be disposed at substantially the same level as that of a lower surface of the first portion 310.

Referring to FIG. 11, as another example, the first portion 310 of the barrier pattern 300 may be formed of multiple layers, and the second portion 320 may be formed of a single layer. The description provided with reference to FIGS. 1 to 10 is applicable to the remaining plurality of items unless context indicates otherwise.

As described in FIG. 9, the first portion 310 may include the first pattern portion 311 disposed between the first conductivity type epitaxial layer 131 and the gate trench 160 and the second pattern portion 312 disposed between the first pattern portion 311 and the gate trench 160. In this case, the second portion 320 may be integrally formed with the second pattern portion 312. The second portion 320 may include the same material as that of the second pattern portion 312. In some embodiments, the first pattern portion 311 may protrude from the lower surface 320_B of the second portion 320 toward the first conductivity type substrate 110. The lower surface 311_B of the first pattern portion 311 may be disposed at a lower level than that of the lower surface 320_B of the second portion 320. For example, the lower surface 311_B of the first pattern portion 311 may be disposed closer to the upper surface of the first conductivity type substrate than the lower surface 320_B of the second portion 320. A lower surface of the second pattern portion 312 may be disposed farther from the upper surface of the first conductivity type substrate than the lower surface 320_B of the second portion 320, but the present invention is not limited thereto.

Hereinafter, a semiconductor device according to some embodiments will be described with reference to FIGS. 12 to 17. The description provided with reference to FIGS. 1 to 11 is applicable to the remaining plurality of items unless context indicates otherwise.

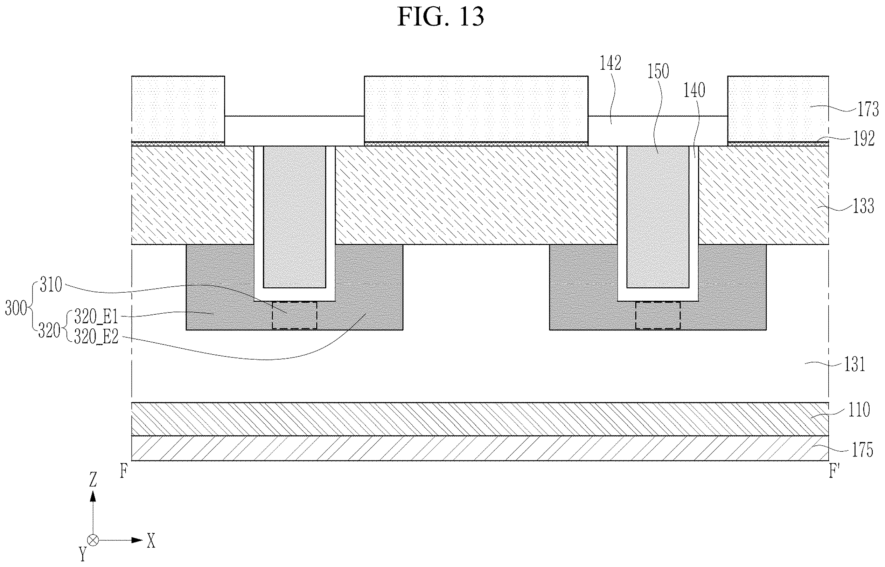

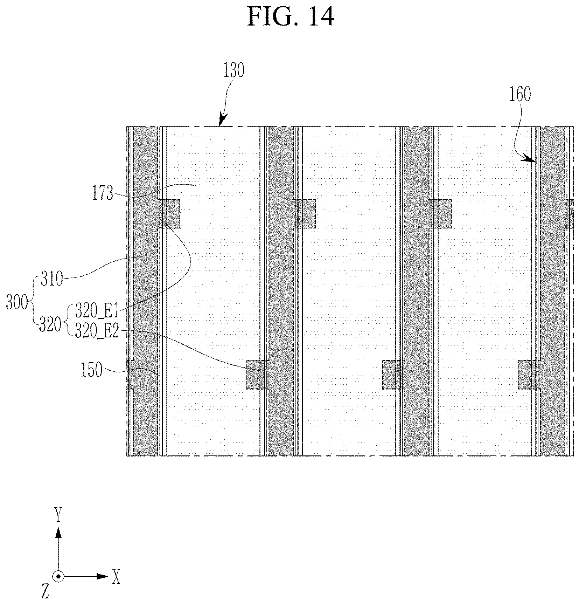

FIG. 12 is a plan view showing a semiconductor device according to some embodiments. FIG. 13 is a cross-sectional view cut along a line F-F' of FIG. 12. Each of FIGS. 14 to 17 is a plan view showing a semiconductor device according to some embodiments.

FIGS. 12 to 17 illustrate various modified examples of the semiconductor device according to the embodiment illustrated in FIGS. 1 to 5. Because the embodiment shown in FIGS. 12 to 17 has the same portion as that of the embodiment shown in FIGS. 1 to 5, a description thereof will be omitted and a difference between the embodiment shown in FIGS. 12 to 17 and the embodiment shown in FIGS. 1 to 5 will be mainly described. Additionally, the same reference numeral is used for a component that is the same as that of the previous embodiment.

The barrier pattern 300 of the semiconductor device according to some embodiments may have various planar shapes.

Referring to FIG. 12 and FIG. 13, for example, the second portion 320 of the barrier pattern 300 may include protruding portions 320_E1 and 320_E2 protruding from one side of the first portion 310.

In some embodiments, the second portion 320 may include the first protruding portion 320_E1 protruding in the second direction (the Y direction) from one side of the first portion 310 and the second protruding portion 320_E2 protruding in the second direction (the Y direction) from the other side of the first portion 310.

Upper surfaces of the first protruding portion 320_E1 and the second protruding portion 320_E2 may be in contact with the second conductivity type doping well 133. Accordingly, each of the first protruding portion 320_E1 and the second protruding portion 320_E2 may be electrically connected to the source electrode 173 through the second conductivity type doping well 133.

Each of the first protruding portion 320_E1 and the second protruding portion 320_E2 may extend in the first direction (the X direction). In some embodiments, a plurality of first protruding portions 320_E1 and a plurality of second protruding portions 320_E2 may be provided to be disposed at opposite sides of each of the plurality of first portions 310 disposed to be spaced apart from each other in the first direction (the X direction). In this case, the first protruding portion 320_E1 and the second protruding portion 320_E2 that face each other along the first direction (the X direction) may be spaced apart from each other.

Referring further to FIG. 14, in some embodiments, the first protruding portion 320_E1 and the second protruding portion 320_E2 may be disposed to be misaligned with respect to each other along the second direction (the Y direction). In this case, the first protruding portion 320_E1 may not overlap the second protruding portion 320_E2 in the second direction (the Y direction), but the present invention is not limited thereto, and the first protruding portion 320_E1 may overlap the second protruding portion 320_E2 in the second direction (the Y direction).

Referring to FIGS. 15 to 17, the second portion 320 of the barrier pattern 300 of the semiconductor device according to some embodiments may extend in a direction different from a direction in which the first portion 310 extends.

For example, as illustrated in FIG. 15, the second portion 320 may extend in a first diagonal direction DR1 intersecting the first direction (the X direction) and the second direction (the Y direction). In this case, the second portion 320 may be disposed between the plurality of first portions 310 that are disposed spaced apart along the first direction (the X direction). Because the second portion 320 extends in the first diagonal direction DR1, the second portion 320 may electrically and physically connect the plurality of first portions 310 adjacent to each other in the first direction (X direction).

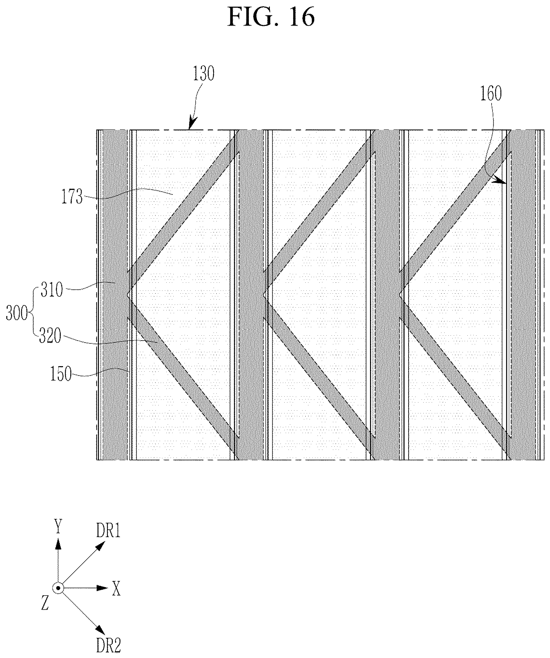

As another example, as illustrated in FIG. 16, the second portion 320 may include a portion extending in the first diagonal direction DR1 intersecting the first direction (the X direction) and the second direction (the Y direction) and a portion extending in a second diagonal direction DR2 intersecting the first direction (the X direction), the second direction (the Y direction), and the first diagonal direction DR1. In this case, the second portion 320 may be disposed between the plurality of first portions 310 that are disposed spaced apart along the first direction (the X direction), but the present invention is not limited thereto. For example, at least some of a plurality of second portions 320 disposed between the plurality of first portions 310 may include the portion extending in the first diagonal direction DR1 and the portion extending in the second diagonal direction DR2, and others of the plurality of second portions 320 disposed between the plurality of first portions 310 may extend in the first diagonal direction DR1 or the second diagonal direction DR2. In some embodiments, the second portion 320 may electrically and physically connect the plurality of first portions 310 adj acent to each other in the first direction (the X direction).

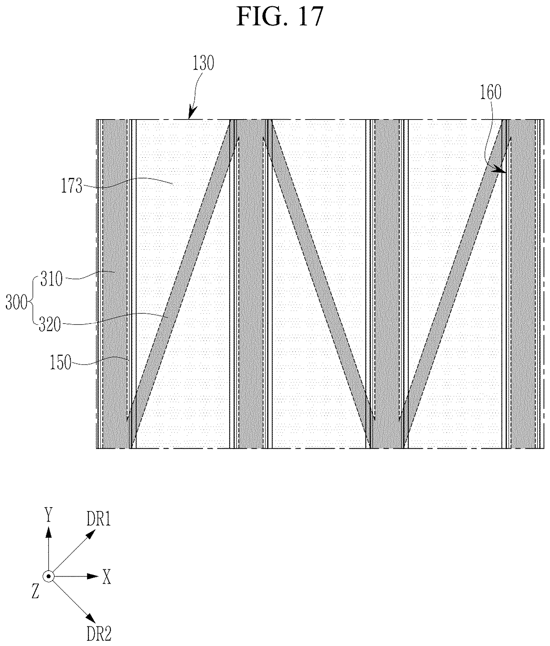

As another example, as illustrated in FIG. 17, at least some of the plurality of second portions 320 disposed between the plurality of first portions 310 may extend in the first diagonal direction DR1, and others of the plurality of second portions 320 disposed between the plurality of first portions 310 may extend in the second diagonal direction DR2.

In the embodiment of FIGS. 15 to 17, a shape of the second portion 320 of the barrier pattern 300 is only an example, and a shape and an extending direction of the second portion 320 may be variously changed.

Referring to FIGS. 1 to 17 and their related description discussed previously, in some embodiments of the invention, a power semiconductor transistor may include a semiconductor layer having first conductivity type (e.g., n-type) and a single-crystalline structure. The semiconductor layer may include a first conductivity type substrate 110 and a first conductivity type epitaxial layer 131. In an embodiment, the semiconductor layer may be the first conductivity type epitaxial layer 131. In another embodiment, the first conductivity type epitaxial layer 131 may be provided with first conductivity type substrate 110. Accordingly, the first conductivity type substrate 110 and the first conductivity type epitaxial layer 131 may be collectively referred to as a single term, e.g., a semiconductor layer.

The semiconductor transistor may further include a barrier pattern 300, a second conductivity type doping region and a pair of first conductivity type doping layers 137 which are provided with the semiconductor layer. The first conductivity type doping layers 137 may be source doping layers. The source doping layer 137 may have first conductivity type (e.g., n-type). The second conductivity type doping region may include a second conductivity type (e.g., p-type) doping well 133 and a second conductivity type doping layer 139. A doping concentration of the second conductivity type doping layer 139 may be greater than a doping concentration of the second conductivity type doping well 133.

The semiconductor transistor may further include a first conductive electrode (source electrode) 173 formed on a first surface of the semiconductor layer. The first conductive electrode 173 may be directly electrically connected to the barrier pattern 300 through the second conductivity type doping region.

The semiconductor transistor may further include a second conductive electrode (drain electrode) 175 formed on a second surface of the semiconductor layer. The first and second surfaces of the semiconductor layer may face away from each other.

The semiconductor transistor may further include a gate electrode 150 disposed in a gate trench 160. The gate electrode 150 may be formed within the semiconductor layer and extend in a first direction (e.g., Y direction). The semiconductor layer may further include a gate insulating layer 140 disposed between the semiconductor layer and the gate electrode 150.

The pair of source doping layers 137 may be disposed within the second conductivity type doping region, and spaced apart from the semiconductor layer by the second conductivity type doping region. The barrier pattern 300 may be disposed on a bottom portion of the gate trench 160, and in contact with the second conductivity type doping region.

The gate electrode 150 may have a first portion and a second portion, which are apart from each other in the first direction in a plan view. In the first portion of the gate electrode 150, the pair of source doping layers 137 may be in contact with the gate insulating layer 140 in a cross-sectional view (e.g., as shown in FIG. 3). The pair of source doping layer 137 may be in contact with the first conductive electrode 173.

In the second portion of the gate electrode 150, the pair of source doping layer 137 may be spaced apart from the gate insulating layer 140 in a cross-sectional view (e.g., as shown in FIG. 4) by the second conductivity type doping region. In a cross-sectional view, the second conductivity type doping region is in contact with two opposite sides of the gate insulating layer 140 and in contact with the first conductive electrode 173.

The first conductive electrode may be directly electrically connected to the second conductivity type doping well 133 through the second conductivity type doping layer 139. The barrier pattern 300 may have second conductivity type (e.g., p-type), and a doping concentration (net concentration of the dominant impurities) of the barrier pattern 300 may be greater than a doping concentration (net concentration of the dominant impurities) of the second conductivity type doping well 133.

The first conductive electrode 173 may be configured to apply a first voltage (e.g., ground voltage) to the source doping layers 137 and to the barrier pattern 300 through the second conductivity type doping region. The gate electrode 150 may be configured to flow a current between the source doping layers 137 and the second conductive electrode 175 though the second conductivity type doping region by applying a second voltage (e.g., a positive voltage) to the gate electrode 150.

As shown in the drawings above, a plurality of gate electrodes 150, a plurality of gate trenches 160, a plurality of sources doping layers 137, a plurality of second conductivity type doping layers and a plurality of barrier patterns 300 may be repeatedly arranged in the X direction and/or Y direction. The plurality barrier patterns 300 may be directly connected to each other, and may have a mesh shape in a plan view. For example, the planar layouts of FIGS. 1, 6, 12, and 14-17 may be repeated and arranged continuously along the X direction and/or Y direction.

As used herein, components described as being "electrically connected" are configured such that an electrical signal can be transferred from one component to the other (although such electrical signal may be attenuated in strength as it is transferred and may be selectively transferred). Moreover, components that are "directly electrically connected" form a common electrical node through electrical connections by one or more conductors, such as, for example, wires, pads, internal electrical lines, through vias, etc. As such, directly electrically connected components do not include components electrically connected through active elements, such as transistors or diodes (e.g., PN junctions).

While this disclosure has been described in connection with what is presently considered to be practical embodiments, it should be understood that the invention is not limited to the disclosed embodiments, but, on the contrary, is intended to cover various modifications and equivalent arrangements included within the scope of the appended claims.

Embodiments are set out in the following clauses:
Clause 1: A semiconductor device comprising:
   first conductivity type substrate;
   a first conductivity type epitaxial layer disposed on a first surface of the first conductivity type substrate;
   a gate trench disposed in the first conductivity type epitaxial layer;
   a gate electrode disposed within the gate trench;
   a gate insulating layer disposed between the first conductivity type epitaxial layer and the gate electrode;
   a source electrode disposed above the first conductivity type epitaxial layer;
   a second conductivity type doping well provided with the first conductivity type epitaxial layer and disposed between the first conductivity type epitaxial layer and the source electrode;
   a drain electrode disposed on a second surface of the first conductivity type substrate; and
   a barrier pattern provided with the first conductivity type epitaxial layer,
   wherein the barrier pattern includes a first portion disposed on a lower surface of the gate trench and a second portion connected to the first portion and disposed between the first conductivity type epitaxial layer and the second conductivity type doping well, and
   wherein the first and second portions are elongated in different directions from each other.
Clause 2: The semiconductor device of clause 1,
   wherein a width of the first portion is less than or equal to a width of the gate electrode.
Clause 3: The semiconductor device of clause 1,
   wherein a width of the first portion is less than or equal to a width of the gate trench.
Clause 4: The semiconductor device of any preceding clause,
   wherein the barrier pattern has a second conductivity type.
Clause 5: The semiconductor device of any preceding clause,
   wherein the first portion overlaps the gate electrode and the second portion does not overlap the second conductivity type doping well.
Clause 6: The semiconductor device of clause 5,
   wherein the second portion overlaps the source electrode and the first portion does not overlap the source electrode.
Clause 7: The semiconductor device of any preceding clause,
   wherein a lower surface of the first portion and a lower surface of the second portion are disposed at the same distance from an upper surface of the first conductivity type substrate.
Clause 8: The semiconductor device of clause 7,
   wherein the second portion surrounds at least a portion of the gate trench.
Clause 9: The semiconductor device of any preceding clause,
   wherein the gate electrode extends in a first direction,
   the first portion extends in the first direction, and
   the second portion extends in a second direction intersecting the first direction.
Clause 10: The semiconductor device of clause 9,
   wherein the second portion includes a first protruding portion protruding from a first side of the first portion and a second protruding portion protruding from a second side of the first portion, and the first and second sides face away from each other.
Clause 11: The semiconductor device of any preceding clause, further comprising:
   a plurality of additional gate electrodes that extend in a first direction; and
   a plurality of additional first portions disposed below the plurality of additional gate electrodes,
   wherein the plurality of additional gate electrodes and the gate electrode are disposed spaced apart from each other in a second direction intersecting the first direction; and,
   wherein the second portion connects the plurality of additional first portions and the first portion.
Clause 12: The semiconductor device of clause 11,
   wherein the plurality of additional first portions and the first portion extend in the first direction and are disposed spaced apart from each other in the second direction.
Clause 13: The semiconductor device of clause 11 or 12,
   wherein the second portion extends lengthwise in the second direction.
Clause 14: The semiconductor device of clause 11 or 12,
   wherein the second portion includes a portion extending in a first diagonal direction intersecting the first direction and the second direction.
Clause 15: The semiconductor device of any preceding clause, further comprising:
   a first conductivity type doping layer and a second conductivity type doping region that are provided with the first conductivity type epitaxial layer and disposed between the second conductivity type doping well and the source electrode,
   wherein the second portion overlaps the second conductivity type doping region and does not overlap the first conductivity type doping layer.

## Claims

1. A semiconductor device comprising:
a first conductivity type substrate (110);
a first conductivity type epitaxial layer (131) disposed on a first surface of the first conductivity type substrate (110);
a gate trench (160) disposed in the first conductivity type epitaxial layer (131);
a gate electrode (150) disposed within the gate trench (160);
a gate insulating layer (140) disposed between the first conductivity type epitaxial layer (131) and the gate electrode (150);
a source electrode (173) disposed above the first conductivity type epitaxial layer (131);
a second conductivity type doping well (133) provided with the first conductivity type epitaxial layer (131) and disposed between the first conductivity type epitaxial layer (131) and the source electrode (173);
a drain electrode (175) disposed on a second surface of the first conductivity type substrate (110); and
a barrier pattern (300) provided with the first conductivity type epitaxial layer (131),
wherein the barrier pattern (300) includes a first portion (310) disposed on a lower surface of the gate trench (160) and a second portion (320) connected to the first portion (310) and disposed between the first conductivity type epitaxial layer (131) and the second conductivity type doping well (133), and
wherein the first and second portions (310, 320) are elongated in different directions from each other.

2. The semiconductor device of claim 1,
wherein a width (W1) of the first portion (310) is less than or equal to a width (W3) of the gate electrode (150).

3. The semiconductor device of claim 1,
wherein a width (W1) of the first portion (310) is less than or equal to a width (W2) of the gate trench (160).

4. The semiconductor device of any preceding claim,
wherein the barrier pattern (300) has a second conductivity type.

5. The semiconductor device of any preceding claim,
wherein the first portion (310) overlays the gate electrode (150) and does not overlay the second conductivity type doping well (133).

6. The semiconductor device of claim 5,
wherein the source electrode (173) overlays the second portion (320) and the source electrode (173) does not overlay the first portion (310).

7. The semiconductor device of any preceding claim,
wherein a lower surface (310_B) of the first portion (310) and a lower surface (320_B) of the second portion (320) are disposed at the same distance from an upper surface of the first conductivity type substrate (110).

8. The semiconductor device of claim 7,
wherein the second portion (310) surrounds at least a portion of the gate trench (160).

9. The semiconductor device of any preceding claim,
wherein the gate electrode (150) extends in a first direction,
the first portion (310) extends in the first direction, and
the second portion (320) extends in a second direction intersecting the first direction.

10. The semiconductor device of claim 9,
wherein the second portion (320) includes a first protruding portion (320_E1) protruding from a first side of the first portion (310) and a second protruding portion (320_E2) protruding from a second side of the first portion (310), and the first and second sides face away from each other.

11. The semiconductor device of any preceding claim, further comprising:
a plurality of additional gate electrodes that extend in a first direction; and
a plurality of additional first portions disposed below the plurality of additional gate electrodes,
wherein the plurality of additional gate electrodes and the gate electrode (150) are disposed spaced apart from each other in a second direction intersecting the first direction; and,
wherein the second portion (320) connects the plurality of additional first portions and the first portion (310).

12. The semiconductor device of claim 11,
wherein the plurality of additional first portions and the first portion (310) extend in the first direction and are disposed spaced apart from each other in the second direction.

13. The semiconductor device of claim 11 or 12,
wherein the second portion (320) extends lengthwise in the second direction.

14. The semiconductor device of claim 11 or 12,
wherein the second portion (320) includes a portion extending in a first diagonal direction (DR1) intersecting the first direction and the second direction.

15. The semiconductor device of any preceding claim, further comprising:
a first conductivity type doping layer (137) and a second conductivity type doping region (134) that are provided with the first conductivity type epitaxial layer (131) and disposed between the second conductivity type doping well (133) and the source electrode (173),
wherein the second conductivity type doping region (134) overlays the second portion (320) and the first conductivity type doping layer (137) does not overlay the second portion (320).
